# EUROPEAN PATENT SPECIFICATION

(11) **EP 1 220 041 B1**
(45) Date of publication and mention of the grant of the patent: **17.09.2008**
(21) Application number: 01130267.6
(22) Date of filing: 20.12.2001
(51) Int. Cl.: G03F 7/32, G03F 7/021

(54) **Method for preparing lithographic printing plate**
Verfahren zur Erzeugung einer Flachdruckplatte
Procédé pour fabriquer une plaque d'impression lithographique

(30) Priority: 26.12.2000 JP 2000394046
(43) Date of publication of application: 03.07.2002
(73) Proprietor: FUJIFILM Corporation, Minato-ku Tokyo (JP)
(72) Inventor: Mitsumoto, Tomoyoshi, Fuji Photo Film Co., Ltd., Haibara-gun, Shizuoka-ken (JP)
(74) Representative: HOFFMANN EITLE

(56) References cited:
- EP-A- 0 080 042
- US-A- 4 774 161
- US-A- 5 126 229

## Description

### BACKGROUND OF THE INVENTION

The present invention relates to a method for preparing a lithographic printing plate.

A negative-working presensitized plate useful for making a lithographic printing plate is generally prepared by coating a photosensitive composition on a substrate such as an aluminum plate, irradiating the composition with active light such as an ultraviolet ray through a negative image to polymerize or cross-link the photosensitive composition at the irradiated portion of the composition so that it becomes insoluble to a developer, and dissolving the non-irradiated portion of the composition into the developer to make an image area which receives oil ink and repels water and a non-image area which receives water and repels oil ink. As the photosensitive composition described above, a composition comprising a diazo resin such as a condensate of p-diazodiphenylamine and formaldehyde has been widely utilized. Examples of an aqueous alkaline developer for developing the presensitized plate with such a photosensitive composition comprising a diazo resin include a developer composition comprising benzyl alcohol, an anionic surfactant, an alkaline agent and water disclosed in J.P. KOKAI No. Sho 51-77401, a developer composition comprised of an aqueous solution comprising benzyl alcohol, an anionic surfactant and a water-soluble sulfite disclosed in J.P. KOKAI No. Sho 53-44202, and a developer composition comprising an organic solvent of which solubility to water at room temperature is 10% by weight or less, an alkaline agent and water. In order to improve the develop ability of such developers (the develop ability is defined as an area of a presensitized plate that can be developed with each 1 L developer), it is effective to increase the concentration of the alkaline agent in the developer. However, the photosensitive layer of the presensitized plate to be developed is easily erosible to result in deterioration of the printing durability and sensitivity (capability for image formation) of the plate. Also, there is a strong demand in the printing industry for a decrease in the amount of waste generated from the developer, due to the recent growth in concern about the environment.

### SUMMARY OF THE INVENTION

Accordingly, the purpose of the present invention is to provide a method for preparing a lithographic printing plate by which printing durability and sensitivity is not deteriorated even if a developer having a high developability is used.

The inventor of the present invention found that the aforementioned problems can be solved by a method for preparing a lithographic printing plate comprising; imagewise exposing a negative-working presensitized plate useful for making a lithographic printing plate having a specific photosensitive on a substrate and developing the imagewise exposed plate with an aqueous alkaline developer comprising an alkanolamine in a specific amount, and thus obtained the present invention.

The present invention provides a method as defined in claim 1 or 2.

The method for preparing a lithographic printing plate comprises; imagewise exposing a negative-working presensitized plate useful for making a lithographic printing plate having a photosensitive layer comprising (a) a diazo resin and (b) an organic polymer compound on a substrate and developing the imagewise exposed plate with an aqueous alkaline developer comprising at least one alkanolamine in an amount of 200 mmol/L or more, wherein said (b) organic polymer compound has at least one modified polyvinyl acetal or polyurethane resin comprising at least one acid group.

### [Aqueous alkaline developer]

The aqueous alkaline developer utilized in the method of the present invention essentially comprises at least one alkanolamine and water. Examples of alkanolamine include the compounds represented by the following general formula.

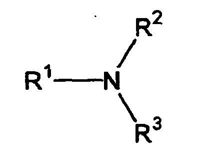

In the formula, R¹, R² and R³ each independently represents -H, - C₂H₄OH, or -C₃H₆OH. However, R¹, R², and R³ do not simultaneously represent -H. Preferred alkanolamine used in the present invention is selected from the group consisting of monoehtanolamine, diethanolamine and triethanolamine and most preferably, triethanolamine. In addition, a combination of two or more alkanolamines may be used.

The total amount of alkanolamine in the aqueous alkaline developer utilized in the present invention should be at least 200mmol/L. It is not preferable if the amount is lower than 200mmol/L, since the plate can not be sufficiently developed. The present invention is characterized by use of a photosensitive layer comprising an organic polymer compound, preferably a modified polyvinyl acetal resin, which does not cause deterioration in sensitivity and printing durability of the obtained lithographic printing plate, even when a developer having such high develop ability is used. The preferred amount of the alkanolamine compound in an aqueous alkaline developer ranges from 200 to 1000 mmol/L.

The developer of the present invention may comprise, in addition to alkanolamine, at least one alkaline agent selected from inorganic alkaline agents such as sodium silicate, potassium silicate, potassium hydroxide, and sodium hydroxide, and organic amines such as triethylamine and diisopropylamine, but within an amount range that does not inhibit the effect of the present invention.

Further, it would be possible to improve the wetting property of the developer so as to wet the photosensitive composition or to further improve the gradation property by adding, in addition to the aforementioned essential components, an anionic surfactant and amphoteric surfactant as disclosed in J. P. KOKAI No. Sho 50- 51324, at least one of the nonionic surfactants, as disclosed in J. P. KOKAI Nos. Sho 59-75255 and Sho 60-111246, or polyelectrolyte as disclosed in J.P. KOKAI Nos. Sho 55-95946 and Sho 56-142528. Among these components, anionic surfactant is preferred.

Examples of anionic surfactants include salt of higher (C₈₋₂₂) alcohol sulfate (e.g., sodium salt of lauryl alcohol sulfate, sodium salt of octyl alcohol sulfate, ammonium salt of lauryl alcohol sulfate (trade name "Teepol B-81", available from Shell Chemical), second sodium alkyl sulfate and the like), salt of fatty alcohol phosphate (e.g., sodium salt of cetyl alcohol phosphate), salt of alkylarylsulfonic acid (e.g., sodium salt of dodecylbenzenesulfonic acid, sodium salt of isopropylnaphthalenesulfonic acid, sodium salt of dinaphthalenedisulfonic acid and sodium salt of metanitrobenzenesulfonic acid), sulfonic acid salt of alkylamide (e.g.,C₁₇H₃₃CON(CH₃)CH₂CH₂SO₃Na and the like), and sulfonic acid salt of dibasic fatty acid ester (e.g., sodium sulfosuccinic acid dioctyl ester, sodium sulfosuccinic acid dihexyl ester). Among the surfactants, sodium isopropylnaphthalenesulfonate (trade name "Aerosol OS", available from American Cyanamide) is preferable since this compound is effective even in a small amount when it is used in combination with benzyl alcohol.

The amount of the surfactant and polyelectrolyte to be added ranges preferably from 0.1 to 5% by weight and more preferably from 0.5 to 3 % by weight, but is not limited thereto.

In addition, the developer of the present invention may comprise an aqueous sulfite, if necessary. Preferred examples of such aqueous sulfite include alkali or alkaline earth metal salt of sulfurous acid such as sodium sulfite, potassium sulfite, lithium sulfite, magnesium sulfite and the like. The amount of the sulfite in the developer composition may range from 0 to 4% by weight and preferably from 0 to 1% by weight.

Further, in place of the aqueous sulfite described above, an alkaline-soluble pyrazolone compound, an alkaline-soluble thiol compound, or a hydroxyl aromatic compound such as methylresorcin may be added to the developer. In addition, it would be possible to use an aqueous sulfite compound with these above compounds. The developer used in the invention may optionally comprise additives such as an antifoaming agent and a water softener. A preferred example of the antifoaming agent includes a silicone-type one. Examples of water softener include salts of polyphosphoric acid and polyaminocarboxylic acids. The optimum amount of the water softener varies depending on the hardness and the amount of the hard water to be used, but the amount thereof generally ranges from 0.01 to 5% by weight and preferably 0.01 to 0.5% by weight on the basis of the total weight of the developer practically used.

The developer utilized in the present invention may comprise, if necessary, a specific kind of organic solvent. A preferred organic solvent is capable of dissolving or swelling a non-exposed area (non-imaging area) of the photosensitive layer when the plate is immersed in the developer and has solubility of 10% by weight or below to water at an ordinary temperature. Examples of such a solvent are described below, but not limited thereto; carboxylate compounds (ester of carboxylic acid) such as ethyl acetate, butyl acetate, benzyl acetate, ethylene glycol monobutyl acetate, butyl lactate and butyl levulinate; ketone compounds such as methyl isobutyl ketone and cyclohexanone; alcohols such as ethylene glycol monobutyl ether, ethylene glycol benzyl ether, ethylene glycol monophenyl ether, benzyl alcohol, methyl phenyl carbinol, n-amyl alcohol and methylamyl alcohol; alkyl-substituted aromatic hydrocarbons and halogenated hydrocarbons. A combination of two or more solvents described above also can be used. Among the solvents, ethylene glycol monophenyl ether and benzyl alcohol are especially useful. The amount of the solvents in the developer may range approximately from 0 to 20% by weight. Especially, preferable results can be obtained when the solvent is used in the amount ranging from 2 to 10% by weight.

In addition, a certain solubilizer to aid dissolution of the aforementioned organic solvent in water may be added to the developer. As such a solubilizer, it is preferable to use alcohols or ketones having a lower molecular weight and higher water-solubility than those of the organic solvent to be used. In addition, an anionic surfactant, amphoteric surfactant and the like can be used. Preferred examples of the surfactant include sodium isopropylnaphthalenesulfonate, sodium N-methyl-N-pentadecylaminoacetate, and sodium lauryl sulfate.

However, the developer comprising any organic solvent may cause many problems (e.g., health problems such as toxicity and a bad odor occurring during work, safety problems such as fire and gaseous explosion, workability problems such as generation of foam, pollution problems such as waste water, cost and the like). Therefore, it is more preferable that the developer substantially not be comprised of any organic solvent.

For example, the aqueous alkaline developer of the present invention may be those comprising a specific amount of alkanolamine and, as a base composition, an aqueous alkaline developer substantially comprising no organic solvent as described in J.P. KOKAI Nos. Sho 59-84241, 57-192952 and 62-24263.

### [Photosensitive layer]

The photosensitive layer used in the method of the present invention comprises a photosensitive composition comprising (a) a diazo resin and (b) an organic polymer compound. The photosensitive layer may comprise a photo-polymerizable composition comprising a polymerizable compound having an ethylenically unsaturated bond, an initiator of photopolymerization and a polymer compound, in addition to the (a) diazo resin and (b) organic polymer compound.

### (I) Organic polymer compound

The organic polymer compound (b) used in the photosensitive layer includes a modified polyvinyl acetal resin comprising at least one acid group or a polyurethane resin comprising at least one acid group. It may additionally include polyamide resin, epoxy resin, acrylic resin, methacrylic resin, polystyrene resin or novolak-type phenol resin. Modified polyvinyl acetal resin comprising at least one acid group or a polyurethane resin comprising at least one acid group are used since the printing durability and sensitivity of the photosensitive layer comprised of such resin do not deteriorate. Further, the modified polyvinyl acetal resin comprising one acid group is most preferred because this resin provides not only a nondecreasing effect but also an increasing effect on the sensitivity of the plate, which latter effect is an expected effect. In the present invention, two or more of organic polymer compounds may be used. When two or more compounds are used, it is preferred to use at least one modified polyvinyl acetal resin comprising at least one acid group as one of the compounds.

The aforementioned modified polyvinyl acetal resin comprising at least one acid group will be explained below. The term "acid group" means a group comprising an acidic hydrogen atom of which an acid dissociation constant (pKa) is 7 or less. For example, -COOH, -SO₂NHCOO-, - CONHSO₂-, -CONHSO₂NH-, -NHCONHSO₂- and the like are included. In particular, preferred group is -COOH. The amount of acid in 1 g polyvinyl acetal resin may be preferably in the range of 0.05 to 6 meq. If the amount of acid is less than 0.05 meq, the photosensitive composition can not be sufficiently developed with an aqueous alkaline developer. In contrast, if the amount of acid is more than 6 meq, the abrasion resistance of the photosensitive composition would be deteriorated. The more preferable amount of the acid is in the range from 0.2 to 4 meq.

The word "modified" utilized in the term modified polyvinyl acetal resin means to give a resin a chemical structure and physical property different from that of the original resin by conducting chemical modification at the alcohol portion of the polyvinyl acetal resin.

Examples of such a modified polyvinyl acetal resin include polymers represented by the following general formula, as disclosed in J.P. KOKAI Nos. Sho 61-267042, Sho 61-128123, Sho 62-58242, and Hei 5-165206.

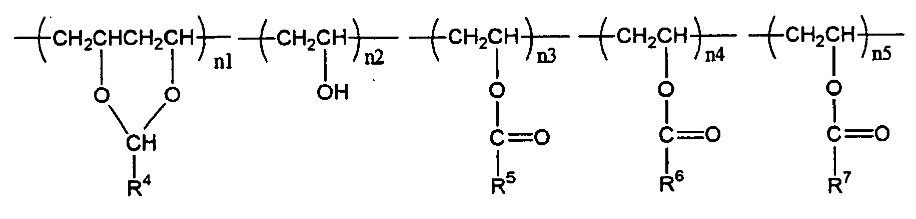

In the formula, R⁴ represents an optionally substituted alkyl group or hydrogen atom, R⁵ represents an optionally substituted alkyl group, R⁶ represents an aliphatic or aromatic hydrocarbon group having carboxylic acid, R⁷ represents an aliphatic or aromatic hydrocarbon group having at least one hydroxyl group or nitrile group and another optional group, and n1, n2, n3, n4, and n5 mean mole % of each respective repeating unit and are in the range of :n1 = 5 ∼ 85, n2 = 0 ∼ 60, n3 = 0 ∼ 20, n4 = 3 ∼ 60, n5=0 ∼ 60.

In the above formula, R⁴ is preferably an optionally substituted C_{1∼8} alkyl group or hydrogen atom, R⁵ is preferably a substituted or unsubstituted C_{1∼4} alkyl group, R⁶ is preferably a C_{1∼8}alkyl group having a carboxylic acid group or a phenyl or naphthyl group having a carboxylic acid group, R⁷ is preferably a C_{1∼8} alkyl group or a phenyl or naphthyl group having at least one hydroxyl or nitrile group and another optional group.

In the above definitions, substituents in the alkyl group may be at least one selected from the group consisting of C_{1∼8} alkyl group, C_{1∼8} alkyloxy group, C_{1∼8} alkylcarbonyl group, phenyl group, phenyloxy group, hydroxyl group, amino group and halogens.

Also, polymers disclosed in J.P. KOKAI No. Sho 60-182437 or polymers having alkenylsulfonylurethane as a side chain disclosed in J.P. KOKAI No. Sho 57-94747 may be preferably used as the organic polymer compound for the photosensitive layer.

The weight-average molecular weight of the modified polyvinyl acetal resin comprising at least one acid group is preferably not less than 10,000 and more preferably from 30,000 to 300,000. These resins may be used alone or in a combination. The amount of the modified polyvinyl acetal resin in the photosensitive layer may be not less than 50% by weight, more preferably from 50 to 99% by weight and still more preferably from about 60 to 95% by weight.

The polyurethane resin usable in the photosensitive layer of the present invention is that comprising at least one acid group. The term "acid group" means a group comprising an acidic hydrogen atom of which the acid dissociation constant (pKa) is 7 or less. Such groups, for example, are -COOH, -SO₂NHCOO-, -CONHSO₂-, -CONHSO₂NH-, -NHCONHSO₂- and the like. In particular, a preferred group is -COOH. The amount of acid in 1 g polyurethane resin may be preferably in the range of 0.05 to 6 meq. If the amount of acid is less than 0.05 meq, developability of the photosensitive composition with an alkaline developer would be insufficient. In contrast, if the amount is more than 6 meq, abrasion resistance of the photosensitive composition would be deteriorated. A more preferable amount of the acid ranges from 0.2 to 4 meq. Details of methods for preparing the aforementioned polyurethane resins are described in J.P. KOKAI Nos. Sho 63-113450 and Hei 5-165206.

The weight-average molecular weight of the polyurethane resin utilized in the present invention is preferably not less than 10,000 and more preferably from 30,000 to 300,000. The polyurethane resin may be used alone or in combination. The amount of the polyurethane resin in the photosensitive layer may be 50% by weight or more, preferably from 50 to 99% by weight and more preferably from about 60 to 95% by weight.

### (II) Diazo resin

Next, (a) diazo resin used in the photosensitive layer of the present invention will be described. (a) Diazo resin suitable for use in the photosensitive layer may be a reaction product of diazonium salt and organic condensation reagent comprising a reactive carbonyl group such as aldol and acetal (so called photosensitive diazo resin), e.g., a condensation product of diphenylamine-p-diazonium salt and formaldehyde, as described in U.S. Patent Nos. 2,063,631 and 2,667,415. Also, other diazo compounds described in J.P.KOKOKU Nos. Sho 49-48001, Sho 49-45322, and Sho 49-45323 are suitable for use as the (a) diazo resin in the photosensitive layer. These diazo compounds are usually obtained in the form of water-soluble inorganic salt. Therefore, the compounds can be applied in the form of aqueous solution.

In addition, as described in J.P.KOKOKU No. Sho 47-41167, these water-soluble diazo compounds can be further reacted with an aromatic or aliphatic compound having one or more phenolic hydroxyl groups, sulfonic acid groups or both hydroxyl and sulfonic acid groups. Thus obtained photosensitive diazo resin that is substantially insoluble in water can also be used as the diazo resin in the photosensitive layer.

Further, it is possible to use a reaction product of a diazonium compound with a hexafluorophosphate compound or tetrafluoroborate compound, as described in J.P. KOKAI No. Sho 56-121031, as the diazo resin in the photosensitive layer.

Examples of the reaction product comprising a phenolic hydroxyl group include hydroxybenzophenone, 4,4-bis(4'-hydroxyphenyl)pentanoic acid, resorcinol, or diphenolic acid such as diresorcinol, which may further comprise any substituent. Examples of hydroxybenzophenone include 2,4-dihydroxybenzophenone, 2-hydroxy-4-methoxybenzophenone, 2,2'-dihydroxy-4,4'-dimethoxybenzophenone and 2,2',4,4'-tetrahydroxybenzophenone.

Examples of a preferable compound comprising a sulfonic acid group include aromatic compounds, such as benzene, toluene, xylene, naphthaline, phenol, naphthol and benzophenone, comprising sulfonic acid, or soluble salts thereof, e.g., ammonium salt and alkali metal salt thereof. The compound comprising sulfonic acid group may further comprise a substituent such as lower alkyl group, nitro group, halo group and/or an additional sulfonic acid group.

Preferred compounds include benzenesulfonic acid, toluenesulfonic acid, naphthalinesulfonic acid, 2,5-dimethylbenzenesulfonic acid, benzenesulfonic acid sodium salt, naphthaline-2-sulfonic acid, 1-naphthol-2 (or 4)-sulfonic acid, 2,4-dinitro-1-naphthol-7-sulfonic acid, 2-hydroxy-4-methoxybenzophenone-5-sulfonic acid, m-(p'-anilinophenylazo)benzenesulfonic acid, alizarin sulfonic acid, o-toluidine-m-sulfonic acid, ethanesulfonic acid and the like. Sulfonic acid esters with alcohol or salts thereof are also useful as the compound comprising sulfonic acid. Generally, such compounds are easily obtainable as an anion surfactant. Examples of such compounds include ammonium salt or alkali metal salt of lauryl sulfate, alkylaryl sulfate, p-nonylphenyl sulfate, 2-phenylethyl sulfate, isooctylethoxydiethoxyethylsulfate and the like.

These substantially water-insoluble photosensitive diazo resins can be isolated as a precipitate by admixing water-soluble photosensitive diazo resin and an aqueous solution of said aromatic or aliphatic compound, preferably in the ratio of equivalence.

In addition, diazo resin described in U.K. Patent No. 1,312,925 is preferably used in the present invention. Moreover, the following diazo resins are also preferably used in the present invention: diazo resin comprising oxy acid of phosphor described in J.P. KOKAI No. Hei 3-253857, diazo resin condensed with a carboxyl group-containing aldehyde or acetal compound thereof described in J.P. KOKAI No. Hei 4-18559, and copolymerized diazo resin with a carboxyl-containing aromatic compound such as phenoxyacetic acid described in J.P.A. No. Hei 3-23031.

The most preferable diazo resin is 2-methoxy-4-hydroxy-5-benzoylbenzenesulfonic acid salt of a condensation product of p-diazodiphenylamine and formaldehyde.

The amount of the diazo resin to be used usually ranges 5 to 50 % by weight based on the total weight of the photosensitive layer. When the amount of diazo resin becomes less, the stability of the resin will be decreased with time, although the sensitivity of the photosensitive layer is consequently improved. The optimum amount of the diazo resin is from about 8 to 20 % by weight.

Hereinafter, a photopolymerizable composition usable as a photosensitive composition for the photosensitive layer of the present invention will be explained. The photopolymerizable composition essentially comprises (a) a diazo resin and (b) an organic polymer compound described above and further comprises a polymerizable compound having an ethylenically unsaturated bond, an initiator of photopolymerization and a polymer compound.

The polymerizable compound having an ethylenically unsaturated bond means a compound having at least one ethylenically unsaturated bond in its structure and being in the form of a monomer, prepolymer (that is, dimer, trimer and other oligomer), mixture thereof or copolymer thereof. Examples of such compounds include unsaturated carboxylic acid, salts thereof, ester of unsaturated carboxylic acid and aliphatic polyalcohol, amide of unsaturated carboxylic acid and aliphatic polyamine and the like.

Examples of the unsaturated carboxylic acid include acrylic acid, methacrylic acid, itaconic acid, crotonic acid, isocrotonic acid, maleic acid and the like.

Examples of the salt of unsaturated carboxylic acid include alkali metal salt such as sodium salt and potassium salt, of the aforementioned acid.

Examples of the ester of an aliphatic polyalcohol compound and unsaturated carboxylic acid include acrylate ester, e.g., ethylene glycol diacrylate, triethylene glycol diacrylate, 1,3-butanediol diacrylate, tetramethylene glycol diacrylate, propylene glycol diacrylate, trimethylolpropane triacrylate, trimethylolethane triacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol triacrylate, dipentaerythritol tetraacrylate, dipentaerythritol hexaacrylate, sorbitol triacrylate, sorbitol tetraacrylate, sorbitol pentaacrylate, sorbitol hexaacrylate, polyester acrylate oligomer and the like.

Examples of the methacrylate ester include tetramethylene glycol dimethacrylate, trimethylene glycol dimethacrylate, trimethylolpropane trimethacrylate, trimethylolethane trimethacrylate, ethylene glycol dimethacrylate, 1,3-butanediol dimethacrylate, pentaerythritol dimethacrylate, pentaerythritol trimethacrylate, dipentaerythritol dimethacrylate, sorbitol trimethacrylate, sorbitol tetramethacrylate, bis-[p-(3-methacryloxy-2-hydroxypropoxy)phenyl]dimethylmethane, bis[p-(methacryloxyethoxy)phenyl]dimethylmethane and the like.

Examples of the itaconate ester include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate and the like.

Examples of crotonic acid ester include ethylene glycol dicrotonate, tetramethylene glycol dicrotonate, pentaerythritol dicrotonate, sorbitol tetracrotonate and the like.

Examples of isocrotonic acid ester include ethylene glycol diisocrotonate, pentaerythritol diisocrotonate, sorbitol tetraisocrotonate and the like.

Examples of maleate ester include ethylene glycol dimaleate, triethylene glycol dimaleate, pentaerythritol dimaleate, sorbitol tetramaleate and the like.

Also, mixtures of the aforementioned esters may be included in the above examples.

Examples of amide compounds of aliphatic polyamine and unsaturated carboxylic acid include methylenebis-acrylamide, methylenebismethacrylamide, 1,6-hexamethylenebis-acrylamide, 1,6-hexamethylenebismethacrylamide, diethylenetriaminetrisacrylamide, xylylenebisacrylamide, xylylenebismethacrylamide and the like.

Other examples of the polymerizable compound include a vinyl urethane compound having a molecule comprising two or more polymerizable vinyl groups, which can be prepared by addition of a vinyl monomer comprising a hydroxyl group shown below (general formula (XIII)) to a polyisocyanate compound having a molecule comprising at least two isocyanate groups as described in J.P.KOKOKU No. Sho 48-41708.

CH₂=C(R)COOCH₂CH(R')OH (XIII)

(wherein, each R and R' represents a hydrogen atom or methyl group.)

Examples of the initiator of photopolymerization include a vicinal polyketaldonyl compound disclosed in U.S. Patent No. 2,367,660, an α-carbonyl compounds disclosed in U.S. Patent Nos. 2,367,661 and 2,367,670, an acyloin ether disclosed in U.S. Patent No. 2,448,828, an aromatic acyloin compound having a hydrocarbon group at α-position as disclosed in U.S. Patent No. 2,722,512, polynuclear quinone compounds disclosed in U.S. Patent Nos. 3,046,127 and 2,951,758, a combination of triarylimidazole dimer/p-aminophenylketone disclosed in U.S. Patent No. 3,549,367, benzothiazoles disclosed in U.S. Patent No. 3,870,524, benzothiazoles/trihalomethyl-s-triazines disclosed in U.S. Patent No. 4,239,850, acridines and phenazines disclosed in U.S. Patent No. 3,751,259, and oxadiazoles disclosed in U.S. Patent No. 4,212,970. The amount of the compound may range from about 0.5% to about 15% by weight and preferably from 2% to 10% by weight based on the total weight of the photopolymerizable composition.

Examples of polymer compounds usable in the present invention include a copolymer of benzyl (meth)acrylate/(meth)acrylic acid/other optional addition-polymerizable vinyl monomer as disclosed in J.P.KOKOKU No. Sho 59-44615; copolymer of methacrylic acid/methyl methacrylate or methacrylic acid/alkyl methacrylate as disclosed in J.P.KOKOKU No. Sho 54-34327, (meth)acrylic acid copolymer as disclosed in J.P.KOKOKU No. Sho 58-12577, J.P.KOKOKU No. Sho 54-25957, and J.P. KOKAI No. Sho 54-92723, copolymer of allyl (meth)acrylate/(meth)acrylic acid/other optional addition-polymerizable vinyl monomer as disclosed in J.P. KOKAI No. Sho 59-53836, addition products of maleic anhydride copolymers and pentaerythritol triacrylates through half-esterification as disclosed in J.P. KOKAI No. Sho 59-71048, and an acidic vinyl polymer with an acid value of 50 to 200 having a -COOH, -PO₃H₂, -SO₃H, -SO₂NH₂, - SO₂NHCO- group in a polymer such as a copolymer of vinyl methacrylate/methacrylic acid/other optional addition-polymerizable vinyl monomer.

Among said polymers, a copolymer of benzyl (meth)acrylate/(meth)acrylic acid/other optional addition-polymerizable vinyl monomer and a copolymer of allyl (meth)acrylate/(meth)acrylic acid/other optional addition-polymerizable vinyl monomer are preferable. These polymer compounds can be used alone or in a combination of two or more compounds. The molecular weight of these polymer compounds may widely vary depending on the kind of compounds, but generally, it is in the range of from 5,000 to 1,000,000 and preferably from 10,000 to 500,000. The amount of the polymer compound may range from 10% to 90% by weight and preferably from 30% to 85% by weight based on the total weight of the photopolymerizable composition.

In addition to the above components, it is preferred that the photosensitive layer further comprises an inhibitor for heat polymerization. For example, hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), 2-mercaptobenzimidazol and the like are suitable for use as the inhibitor.

Moreover, in order to prevent inhibition of polymerization by oxygen in air, a wax can be added to the photosensitive layer. Wax usable in the present invention is in a solid form at an ordinary temperature but dissolves in a coating solution and precipitates during coating and drying processes. Examples of such wax include higher fatty acid such as stearic acid and behenic acid, higher fatty acid amide such as stearylamide and behenylamide, higher alcohol and the like.

In order to completely protect the photosensitive layer from inhibition of polymerization by oxygen in air, a protective layer comprising a polymer which is excellent in blocking oxygen such as polyvinyl alcohol, acidic celluloses and the like may be formed on the photosensitive layer. For example, a method for formation of such a protective layer is described in U.S. Patent No. 3,458,311, and J.P.KOKOKU No. Sho 55-49729.

The photosensitive composition used in the present invention may comprise a colorant, which is used for obtaining a visible image after the negative-working presensitized plate is imagewise exposed to light and after the imagewise exposed plate is developed. The preferable colorants are those providing a change of color tone through a reaction with free radicals or acids. The phrase a "change of color tone" include the meaning of a change of a colorless tone to colored tones, a change of a colored tone to a colorless tone, and a change of a color tone to other color tones. Preferred colorants may be those which form a salt with an acid to change their color.

Specific examples of a colorant which is initially colored and is converted into a colorless tone, or which causes a color change include triphenylmethanes, diphenylamines, oxazins, xanthenes, iminonaphthoquinones, azomethenes or anthraquinones dye such as Victoria Pure Blue and naphthalenesulfonic acid salt thereof (available from Hodogaya Chemical Co., Ltd.), Oil Blue #603 (available from Orient Chemical Industries, Co., Ltd.), Patent Pure Blue (available from Sumitomo Mikuni Chemical Co., Ltd.), Crystal Violet, Brilliant Green, Methyl Violet, Ethyl Violet, Methyl Green, Erythrosine B, Basic Fuchsine, Malachite Green, Oil Red, m-Cresol Purple, Rhodamine B, Auramine, 4-p-diethylaminophenyl iminonaphthoquinone, and cyano-p-diethylaminophenyl acetanilide,

Examples of a colorant which is initially colorless and is converted into a colored tone include leuco dyes and primary or secondary arylamine type dyes such as triphenylamine, diphenylamine, o-chloroaniline, 1,2,3-triphenylguanidine, naphthylamine, diaminodiphenylmethane, p,p'-bis-dimethylaminodiphenylamine, 1,2-dianilinoethylene, p,p',p"-tris-dimethylaminotriphenylmethane, p,p'-bis-dimethylaminodiphenylmethylimine, p,p',p"-triamino-o-methyltriphenylmethane, p,p'-bis-dimethylaminodiphenyl-4-anilinonaphthylmethane and p,p',p"-triaminotriphenylmethane.

Especially preferred as such a colorant are triphenylmethane type dyes and diphenylmethane type dyes, triphenylmethane type dyes being more preferable, and in particular Victoria Pure Blue BOH and naphthalenesulfonic acid salt thereof. The foregoing dyes are used in an amount preferably ranging from about 0.5 to 10% by weight, and more preferably, about 1 to 5% by weight based on the total weight of the photosensitive composition.

The photosensitive composition used in the present invention may optionally comprise other kinds of additives. For example, alkyl ethers (e.g., ethyl cellulose, methyl cellulose), fluorinated surfactants, and nonionic surfactants (especially fluorinated surfactants are preferred) for improving applicability of the composition, a plasticizer for improving the flexibility and wear resistance of the resulting coating layer (e.g., butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate and oligomers and polymers of (meth)acrylic acid, with tricresyl phosphate being particularly preferred), an agent for improving the ink receptivity of images (e.g., styrene/maleic anhydride copolymers half-esterified with alcohols, novolak resins such as p-t-butylphenol-formaldehyde resin and fatty acid esters of p-hydroxystyrene as disclosed in J.P. KOKAI No. Sho 55-527), a stabilizing agent (e.g., phosphoric acid, phosphorous acid, pyrophosphate, phenylphosphonic acid, 5-nitronaphthalene-1-phosphonic acid, 4-chlorophenoxymethylphosphonic acid, citric acid, tartaric acid, oxalic acid, malic acid, propane-1,2,3-tricarboxylic acid, 2-phosphonobutane-1,2,4-tricarboxylic acid, 1-phosphonoethane-1,2,2-tricarboxylic acid, dipicolinic acid, sulfosalicylic acid, 3-sulfophthalic acid, 2-sulfoterephthalic acid, 5-sulfoisophthalic acid, boric acid, p-toluenesulfonic acid, benzenesulfonic acid, p-hydroxybenzenesulfonic acid, isopropylnaphthalenesulfonic acid, t-butylnaphthalenesulfonic acid, 4-methoxy-2-hydroxybenzophenone-5-sulfonic acid, sodium phenyl-methyl-pyrazolonesulfonate, 1-hydroxyethane-1,1-disulfonic acid, tricarballylic acid, polyacrylic acid and copolymers thereof, polyvinylphosphonic acid and copolymers thereof and polyvinylsulfonic acid and copolymers thereof), and an accelerating agent for the development of the presensitized plate (e.g., higher alcohol, acid anhydride and the like) may be preferably used.

Although the amount of each additive to be used in the photosensitive composition depends on the type of photosensitive composition and on the purpose for which the presensitized plate is to be used, generally it ranges from 0.01 to 30% by weight based on the total weight of the solid components. In order to coat the aforementioned photosensitive composition on a substrate, an appropriate amount of the photosensitive diazonium compound, lipophilic polymer compound and optional additives may be dissolved in a suitable solvent (e.g., Methyl Cellosolve ®, Ethyl Cellosolve ®, dimethoxyethane, diethylene glycol monomethyl ether, diethylene glycol dimethyl ether, 1-methoxy-2-propanol, Methyl Cellosolve ® acetate, acetone, methyl ethyl ketone, methanol, dimethylformamide, dimethylacetamide, cyclohexanone, dioxane, tetrahydrofuran, methyl lactate, ethyl lactate, ethylene dichloride, dimethylsulfoxide, and water or mixtures thereof) to prepare a coating solution of photosensitive composition and the solution may be applied onto the substrate followed by drying.

The solvent may be used alone, but it is more preferred to use a mixture of a solvent having a relatively high boiling point such as Methyl Cellosolve ®, 1-methoxy-2-propanol and methyl lactate and a solvent having a relatively low boiling point such as methanol and methyl ethyl ketone. The concentration of the solid components of the photosensitive composition in the coating solution desirably ranges from 1 to 50% by weight. In such a case, the coating amount of the photosensitive composition may be in the range of 0.2 to 10 g/m² (as dry weight), and preferably in the range of 0.5 to 3 g/m².

The aforementioned photosensitive composition may be coated on a suitable substrate to prepare a presensitized plate useful for making a lithographic printing plate. Examples of the suitable substrate include a paper, a paper laminated with a plastic film (such as polyethylene, polypropylene and polystyrene film), a metal plate such as aluminum (including aluminum-containing alloy), zinc and copper plate, a plastic film such as cellulose diacetate, cellulose triacetate, cellulose propionate, polyethylene terephthalate, polyethylene-polypropylene, polycarbonate, polyvinyl acetal and the like, a paper or a plastic film laminated or deposited with the aforementioned metal and a copper plate coated with aluminum or chromium. In particular, an aluminum plate or a composite coated with aluminum is preferably used as a substrate.

The aluminum plate preferably used in the present invention has a thickness in the range of 0.1 to 0.6 mm. In addition, one side or both sides of the presensitized plate useful for making a lithographic printing plate utilized in the present invention may be used, in the case where both sides are treated in the same way. Hereinafter, a treatment of only one side of the plate will be described, but it will be understood that both sides can be treated in a manner similar to that in which one side of the plate is treated as described below to prepare a presensitized plate of which both sides can be utilized.

The surface of the aluminum plate is desirably treated to improve water-holding capacity and adherence to the photosensitive layer. Examples of surface-roughening methods include brush graining, ball graining, electrolytic etching, chemical etching, liquid honing, sand blast graining and a combination thereof. Preferred methods for surface roughening are brush graining, electrolytic etching, chemical etching, and liquid honing, and the most preferred method is to use electrolytic etching. In addition, it is preferable to conduct electrolytic etching after brush graining, as disclosed in J.P. KOKAI No. Sho 54-63902.

An aqueous solution comprising an acid, an alkali or salts thereof, or an aqueous solution comprising an organic solvent may be used as an electrolytic solution used for the electrolytic etching. A preferred electrolytic solution is a solution comprising hydrochloric acid, nitric acid or salts thereof. The surface-roughened aluminum plate may be optionally desmutted with an acid solution or alkaline solution.

The surface of the thus obtained aluminum plate is desirably subjected to anodization, and in particular, the aluminum plate is preferably bathed in a solution comprising a sulfuric acid or phosphoric acid. Also, if necessary, the aluminum plate is further subjected to treatments such as a treatment with a silicate (e.g., sodium or potassium silicate) as disclosed in U.S. Patent Nos. 2,714,066 and 3,181,461; a treatment with potassium fluorozirconate as disclosed in U.S. Patent No. 2,946,638; a treatment with phosphomolybdate as disclosed in U.S. Patent No. 3,201,247; a treatment with an alkyl titanate as disclosed in U.K. Patent No. 1,108,559; a treatment with polyacrylic acid as disclosed in German Patent No. 1,091,443; a treatment with polyvinylphosphonic acid as disclosed in German Patent No. 1,134,093 and U.K. Patent No. 1,230,447; a treatment with a phosphonic acid as disclosed in J.P. KOKOKU No. Sho 44-6409; a treatment with a phytic acid as disclosed in U.S. Patent No. 3,307,951; and a treatment with a divalent metal salt of hydrophilic organic polymer as disclosed in J.P. KOKAI Nos. Sho 58-16893 and Sho 58-16291.

Examples of other hydrophilization treatments include silicate electrodeposition as disclosed in U.S. Patent No. 3,658,662. Moreover, the aluminum plate is preferably subjected to sealing treatment after the surface-graining and anodization treatments. Such sealing treatment may be performed by immersing the aluminum plate in a hot water or a hot aqueous solution containing an inorganic or organic salt, or by treating the plate in a steam bath.

More particularly, a substrate suitable for use in the present invention may be prepared by immersing a 1S aluminum plate comprising 0.1 to 0.5% by weight iron, 0.03 to 0.3% by weight silicon, 0.001 to 0.03% by weight copper and 0.002 to 0.1% by weight titanium, in a solution comprising an alkali, preferably sodium hydroxide, potassium hydroxide, sodium carbonate or sodium silicate, each in an amount ranging from 1 to 30% by weight, at 20 to 80°C for 5 to 250 seconds to etch the plate. Aluminum may be added to the etching bath in an amount of twenty percent based on the alkali amount. Then, the plate may be immersed in a solution comprising nitric acid or sulfuric acid in an amount ranging from 10 to 30 % by weight at 20 to 70°C for 5 to 250 seconds to neutralize and to remove smut after alkali etching.

After the surface of the aluminum plate is cleaned, the plate may be surface-grained as follows. A preferred surface-graining treatment may be brush graining and/or electrolytic etching. In the brush graining, a suspension of pumice stone in water is preferably used and the resulting average roughness of the surface preferably ranges from 0.25 to 0.9 µm. An electrolytic solution used for the electrolytic etching may be an aqueous solution of hydrochloric acid or nitric acid. The amount of the electrolytic solution to be used preferably ranges from 0.01 to 3% by weight and more preferably from 0.05 to 2.5% by weight.

The electrolytic solution may comprise, if necessary, an anticorrosive agent (or a stabilizing agent), or a leveling agent for graining such as nitrate, chloride, monoamines, diamines, aldehydes, phosphoric acid, chromic acid, boric acid, and ammonium salt of oxalic acid. In addition, the electrolytic solution may comprise an aluminum ion in a suitable amount (1 to 10 g/l).

Generally, the treatment of the aluminum plate with the aforementioned electrolytic solution is conducted at the temperature of 10 to 60°C. Alternating current used in the treatment may be any wave such as a square wave, trapezoid wave and sine wave, provided that the positive and negative polarities are alternated in turn. A single-phase and three-phase alternating current that is a typical and commercially available one can be utilized. It is desirable to treat the plate with the current having current density of 5 to 100A/dm² for 10 to 300 seconds.

The roughness of the surface of an aluminum alloy substrate utilized in the present invention may be adjusted to the range of 0.2 to 0.8 µm by controlling the electrical quantity. Thus surface-grained aluminum alloy may be preferably treated with 10 to 50% hot sulfuric acid (40 to 60°C) or a diluted alkali (e.g., sodium hydroxide) to remove the smut adhered to the surface thereof. If the smut is removed from the surface of the aluminum alloy by treating it with alkali, the plate is subsequently immersed in an acid (nitric acid or sulfuric acid) to be neutralized.

After the smut on the aluminum alloy surface is removed, an anodized film may be formed on the aluminum alloy surface. Any of the conventionally well-known methods for anodization can be used for forming the anodized film. However, sulfuric acid is the most useful electrolyte for anodization while phosphoric acid is the second most useful. In addition, a mixture of sulfuric acid and phosphoric acid as disclosed in J.P. KOKAI No. Sho 55-28400 is also a useful electrolyte for anodization in the present invention.

Generally, the anodization with sulfuric acid can be conducted using direct current, but it is also possible to use an alternate current. In the anodization with sulfuric acid, the plate is treated with sulfuric acid at a concentration of 5 to 30 % by weight at 20 to 60°C for 5 to 250 seconds to obtain an oxidized film in an amount ranging from 1 to 10 g/m². The electrolytic solution preferably comprises an aluminum ion and moreover, in such a case, the electric current density to be used preferably ranges from 1 to 20 A/dm².

The anodization with phosphoric acid may be conducted at a concentration of 5 to 50% by weight at 30 to 60°C for 10 to 30 seconds with an electric current density of 1 to 15 A/dm². It is desirable that the thus treated aluminum substrate may be further surface-treated with silicates as disclosed in U.S. Patent No. 2,714,066.

A coating layer of an organic polymer may be applied onto the back face of the presensitized plate of the present invention (hereinafter referred to as the "back coat layer") to prevent elution of the anodized film from the aluminum plate during the development of the presensitized plate and to prevent the occurrence of defects upon handling the plates while arranging them in layers. Materials used for the back coat layer are organic polymers insoluble in water and alkaline developers as disclosed in Japanese Patent Application No. Hei 2-327111. The thickness of the back coat layer may be in such a range that the elution of the anodized film from the aluminum plate during the development of the presensitized plate can be inhibited, and may preferably range from 0.01 to 50µm and more preferably from 0.05 to 10µm. A variety of methods for applying the back coat layer on the backside of the aluminum substrate can be utilized. Among them, the most preferred method to make the thickness of the back coat layer in the aforementioned amount is to prepare a coating solution and to apply the solution on the aluminum substrate followed by drying.

In the present invention, a base coat layer comprising the following compound may be preferably formed on a surface of a substrate. Examples of the compound to be used for the basecoat layer include carboxymethylcellulose, dextrin, gum arabic, phosphonic acids comprising an amino group such as 2-aminoethylphosphonic acid, organic phosphonic acids such as optionally substituted phenylphosphonic acid, naphthylphosphonic acid, alkylphosphonic acid, glycerophosphonic acid, methylenediphosphonic acid and ethylenediphosphonic acid, organic phosphoric acid such as optionally substituted phenylphosphoric acid, naphthylphosphoric acid, alkylphosphoric acid and glycerophosphoric acid, organic phosphinic acid such as optionally substituted phenylphosphinic acid, naphthylphosphinic acid, alkylphosphinic acid and glycerophosphinic acid, amino acids such as glycine and β-alanine, hydrochloric acid salt of hydroxyl group-containing amines such as hydrochloric acid salt of triethanolamine, water-soluble polymer containing a sulfonic acid group as described in J.P. KOKAI No. Sho 59-101651, and acidic dyes as described in J.P. KOKAI No. Sho 60-64352.

The base coat layer may be formed on a substrate by coating on a substrate a solution prepared by dissolving the compounds described above in a solvent such as water, methanol, ethanol, methyl ethyl ketone and mixtures thereof, followed by drying. Moreover, a yellow dye can be added to the solution to improve tone reproduction of the presensitized plates. In general, the amount of the base coat layer ranges from about 2 to 200 mg/m², and preferably 5 to 100 mg/m² (expressed in terms of the dry solid contents).

Further, a mat layer is preferably formed on the surface of the photosensitive layer, wherein the mat layer is comprised of risings each of which is formed separately. The purpose of the mat layer is to improve the adhesiveness between a negative-image film and the presensitized plate during contact exposure to light to reduce the time required for evacuation using a vacuum printing frame and to prevent the association of image micro dots.

The mat layer may be coated on a substrate by methods such as heat fusion of solid powder as disclosed in J.P. KOKAI No. Sho 55-12974, and spraying and drying of water comprising a polymer as disclosed in J.P. KOKAI No. Sho 58-182636. Although any method for forming the mat layer can be utilized, it is desirable for the mat layer to be formed to be soluble in an aqueous alkaline developer comprising substantially no organic solvent, or removable by the developer.

The photosensitive composition coated on a substrate as described above is exposed to light through a transparent original film comprising line and dot images. Then, it is developed with an aqueous alkaline developer comprising alkanolamine described above to obtain a negative relief image.

Hereinafter, the present invention will be described in detail with reference to Examples including methods for preparing the organic polymer and the lithographic printing plate of the present invention.

### [Examples]

### Preparation Examples

### Preparation of polyvinyl acetal resin (A):

In a one-liter volume three-neck round bottom flask equipped with a thermometer, a condenser and an agitator, polyvinyl formal (20 g) (Vinylec B-2, Chisso Co. Ltd.) was dissolved in acetic acid (240 ml) to form a mixture. The reaction temperature was maintained at 100°C and maleic anhydride (16.9g) and sodium acetate (18.0g) were added to the mixture. The reaction was continued for 4 hours. The resulting solution was added portionwise to 4-L solvent that was a mixture of methanol and water (1:3), to precipitate a polymer. Thus obtained solid was dried under vacuum to obtain the desired polymer (21.5 g). The acid content of the polymer was 1.5 meq/g.

### Preparation of polyvinyl acetal resin (B):

In a one-liter volume three-neck round bottom flask equipped with a thermometer, a condenser and an agitator, polyvinyl butyral (60 g) was dissolved in an acetic acid (720 ml) under a heating condition to make a mixture. The reaction temperature was maintained at 100°C and phthalic anhydride (89.8g) and sodium acetate (60.5g) were added to the mixture. The reaction was continued for 3 hours. The resulting solution was added portionwise to 10 L solvent that was a mixture of methanol and water (1:3), to precipitate a polymer. Thus obtained solid was dried under a vacuum to obtain a polymer (64.8 g). The acid content of the polymer was 2.72 meq/g. Next, the modified polyvinyl butyral (45 g) was dissolved in 450 ml DMF under a heating condition to make a mixture. After the temperature of the mixture was adjusted to 80°C, potassium carbonate (6.91 g) and ethylene bromohydrin (6.24 g) was added to the mixture and the reaction was continued for 3 hours. The solution was added portionwise to 5 L solvent that was a mixture of water and acetic acid (19:1), to precipitate a polymer. The solid was dried under a vacuum to obtain the desired polymer (38.4 g). The acid content of the polymer was 1.48 meq/g.

### Preparation of polyvinyl acetal resin (C):

In a one-liter volume three-neck round bottom flask equipped with a thermometer, a condenser and an agitator, polyvinyl butyral (40 g) (DENKABUTYRAL #4000-2, Denki Kagaku Kogyo Co. Ltd.) was dissolved in anhydrous tetrahydrofuran (600 ml) under a heating condition to make a reaction mixture. A mixture of propenylsulfonylisocyanate (18 g) and tetrahydrofuran (100 g) was added to the reaction mixture and the reaction was continued for 4 hours at room temperature. The resulting solution was added portionwise to 10 L water to precipitate a polymer. Thus obtained solid was dried under a vacuum to obtain the desired polymer (49.8 g). The acid content of the polymer was 2.51 meq/g.

### Preparation of urethane resin (A):

In a 500 ml volume three-neck round bottom flask equipped with a condenser and an agitator, 2,2-bis(hydroxymethyl)propionic acid (11.5g, 86mmol), diethylene glycol ether (7.26g, 68.4mmol) and 1,4-butanediol (4.11g, 45.6mmol) were dissolved in N,N-dimethylacetamide (118 g) to make a mixture. 4,4'-Diphenylmethane diisocyanate (30.8g, 123mmol), hexamethylene diisocyanate (13.8g, 81.9mmol) and di-n-butyltin dilaurate (0.1g) as a catalyst were added to the mixture. The mixture was heated at 90°C for 7 hours while stirring it. To the reaction mixture, 100ml N,N-dimethylacetamide, 50ml methanol and 50ml acetic acid were added. After being stirred, the mixture was poured into 4 L water while stirring it to precipitate a white polymer. The polymer was filtered, washed with water and dried under a vacuum to obtain a urethane resin (62 g).

### Preparation of acrylic resin (A):

Under a nitrogen stream, dioxane (300 g) was heated to 100°C and a mixture of 2-hydroxyethyl methacrylate (150 g), acrylonitrile (60 g), methyl methacrylate (79.5 g), methacrylic acid (10.5 g) and benzoyl peroxide (1.2 g) was added dropwise to the dioxane over 2 hours. After the addition was completed, the reaction mixture was diluted with methanol and poured into water to precipitate a copolymer and the copolymer was dried under a vacuum at 70°C.

### Example 1

A surface of a JIS1050 aluminum sheet (plate) was grained with a rotary nylon brush using a suspension of pumice stone in water as an abrasive. The roughness of the thus treated surface of the plate (Ra) was 0.5 µm. After being washed with water, the aluminum plate was immersed in an aqueous solution of 10% sodium hydroxide at 70°C to etch the plate until the amount of dissolved aluminum became 6 g/m². After being washed with water, the aluminum plate was then immersed in a 30% aqueous solution of nitric acid for 1 minute to neutralize the plate and washed completely with water. Then, an electrolytic graining of the plate was conducted in a 0.7% aqueous solution of nitric acid using rectangle alternating continuous wave voltage with an anode voltage of 13 volts and a cathode voltage of 6 volts for 20 seconds. The plate was then immersed in a 20% nitric acid at 50°C to wash its surface, followed by washing it with water. Further, the plate was anodized in a 20% aqueous solution of nitric acid using a direct current to form a porous anodized layer. Electrolysis of the plate was conducted by using an electric current density of 5A/dm² and suitably controlling an amount of time for electrolysis to obtain a substrate having an anodized layer in an amount of 2.5g/m². This substrate was treated with a 0.5% aqueous solution of polyvinylphosphoric acid at 60°C for 5 seconds, washed completely with water and then dried.

On the substrate prepared as described above, a "Coating solution for photosensitive layer (I)" was applied by a rotary applicator so that the amount of the coating became 1.5 g/m² as dry weight and dried at 100°C for 1 minute to obtain a presensitized plate useful for making a lithographic printing plate. The presensitized plate was imagewise exposed by PS light (Fuji Photo Film Co. Ltd.) at a distance of 1 m from the plate for 1 minute, with a Step Tablet (Step Guide available from Fuji Photo Film Co. Ltd., comprising 15 steps and having an optical density difference of 0.15) being close in contact with the plate.

Then, the plate was immersed in a 5 L developer having components shown in "Developer composition (I)" for 10 seconds and immediately washed with water. Next, the plate was treated with the gum referred to as a "Coating solution for desensitizing the plate to grease (I)" using an automatic gumming up machine (G-800H, Fuji Photo Film Co. Ltd.) to obtain a lithographic printing plate. The solid was observed at the 4^{th} step of the Step Tablet.

Then the plate was printed using the SOR-M printer (available from Heidelberg) and Geos (N) black ink (available from Dainippon Ink and Chemicals, Inc.) on quality paper to obtain 50,000 good prints.

The plate was continuously developed in the same way as described above. It was possible to develop 220m² of the plate without any problem, but the developability of the developer was deteriorated (that is, the non-image area could not be removed) when 230m² was treated with the developer.

| Coating solution for photosensitive layer (I) | |
|---|---|
| Polyvinyl acetal resin (A) | 5g |
| Dodecylbenzenesulfonic acid salt of condensation product of 4-diazodiphenylamine and formaldehyde | 1.2g |
| Propane-1,2,3-tricarboxylic acid | 0.05g |
| Phosphoric acid | 0.05g |
| 4-Sulfophthalic acid | 0.05g |
| Tricresil phosphate | 0.25g |
| Half ester of styrene-maleic anhydride copolymer with n-hexanol | 0.1g |
| Victoria Pure Blue BOH | 0.18g |
| Megafac F-177 (Dainippon Ink and Chemicals, Inc.) | 0.015g |
| 1-Methoxy-2-propanol | 20g |
| Methanol | 40g g |
| Methyl ethyl ketone | 40g |
| Ion exchanged water | 1g |

| Developer composition (I) | |
|---|---|
| Sodium sulfite | 1g |
| Benzyl alcohol | 40g |
| Triethanolamine | 40g |
| Sodium isopropylnaphthalenesulfonate | 12g |
| Ion exchanged water | 1000g |

| Coating solution for desensitizing the plate to grease (I) | |
|---|---|
| Gum arabic | 5g |
| White dextrin | 30g |
| Ethylene glycol | 10g |
| Phosphoric acid | 3g |
| Ion exchanged water | 1000g |

### Example 2

The preparation method disclosed in Example 1 was repeated, except that a "Coating solution for photosensitive layer (II)" was substituted for the "Coating solution for photosensitive layer (I)" to obtain a presensitized plate useful for making a lithographic printing plate as disclosed in Example 1. Thus obtained plate was imagewise exposed to light, developed with the developer and treated with the gumming up solution as disclosed in Example 1. The solid was observed at the 4^{th} step of Step Tablet

The plate was continuously developed in the same way as described in Example 1. It was possible to develop 200m² of the plate without any problem, but the developability of the developer was deteriorated (that is, the non-image area could not be removed) when 210m² was treated with the developer.

| Coating solution for photosensitive layer (II) | |
|---|---|
| Polyvinyl acetal resin (B) | 5g |
| Mesitylenesulfonic acid salt of polycondensate of 3-methoxy-4-diazodiphenylamine and 4,4'-bis-methoxymethyldiphenyl ether | 1.2g |
| Propane-1,2,3-tricarboxylic acid | 0.05g |
| Phosphoric acid | 0.05g |
| 4-Sulfophthalic acid | 0.05g |
| Tricresil phosphate | 0.25g |
| Half ester of styrene-maleic anhydride copolymer with n-hexanol | 0.1g |
| Victoria Pure Blue BOH | 0.18g |
| Megafac F-177 (Dainippon Ink and Chemicals, Inc.) | 0.015g |
| 1-Methoxy-2-propanol | 20g |
| Methanol | 40g |
| Methyl ethyl ketone | 40g |
| Ion exchanged water | 1g |

### Example 3

The preparation method disclosed in Example 1 was repeated, except that a "Coating solution for photosensitive layer (III)" was substituted for the "Coating solution for photosensitive layer (I)" to obtain a presensitized plate useful for making a lithographic printing plate as disclosed in Example 1. Thus obtained plate was imagewise exposed, developed and treated as disclosed in Example 1. The solid was observed at the 4^{th} step of Step Tablet

The plate was continuously developed in the same way as described in Example 1. It was possible to develop 210m² of the plate without any problem, but the developability of the developer was deteriorated (that is, the non-image area could not be removed) when 220m² was treated with the developer.

| Coating solution for photosensitive layer (III) | |
|---|---|
| Polyvinyl acetal resin (B) | 2.5g |
| Acrylic resin (A) | 2.5g |
| Dodecylbenzenesulfonic acid salt of condensation product of 4-diazodiphenylamine and formaldehyde | 1.2g |
| Oil Blue #603 (Orient Chemical Industries, Co. Ltd.) | 0.18g |
| Malic acid | 0.05g |
| Megafac F-177 (Dainippon Ink and Chemicals, Inc.) | 0.015g |
| 1-Methoxy-2-propanol | 30g |
| Methyl ethyl ketone | 50g |
| Methanol | 20g |

### Example 4

The preparation method disclosed in Example 1 was repeated, except that "Coating solution for photosensitive layer (IV)" was substituted for "Coating solution for photosensitive layer (I)" to obtain a presensitized plate useful for making a lithographic printing plate as disclosed in Example 1. Thus obtained plate was imagewise exposed, developed and treated as disclosed in Example 1. The solid was observed at the 3^{rd} step of Step Tablet

The plate was continuously developed in the same way as described in Example 1. It was possible to develop 230m² of the plate without any problem, but the developability of the developer was deteriorated (that is, the non-image area could not be removed) when 240m² was treated with the developer.

| Coating solution for photosensitive layer (IV) | |
|---|---|
| Polyvinyl acetal resin (C) | 2.5g |
| Poly(allyl methacrylate/methacrylic acid) copolymer (mole ratio = 70/30) | 2.5g |
| Pentaerythritol tetraacrylate | 1.5g |
| Initiator of photopolymerization described below | 0.3g |
| PF₆ salt of condensation product of 4-diazodiphenylamine and formaldehyde | 0.2g |
| Oil Blue #603 (Orient Chemical Industries, Co. Ltd.) | 0.15g |
| Megafac F-177 (Dainippon Ink and Chemicals, Inc.) | 0.05g |
| Phosphorous acid (50%) | 0.05g |
| Behenic acid amide | 0.1g |
| Ethylene glycol monomethyl ether | 50g |
| Methyl ethyl ketone | 50g |
| Methanol | 20g |

### Initiator for photopolymerization

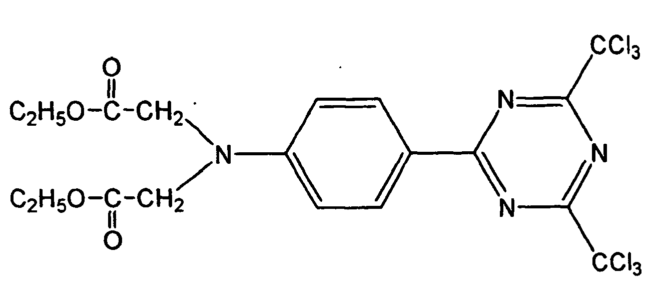

### Example 5

The preparation method disclosed in Example 1 was repeated, except that "Coating solution for photosensitive layer (V)" was substituted for "Coating solution for photosensitive layer (I)" and "Developer solution (II)" was substituted for "Developer solution (I)" to obtain a presensitized plate useful for making a lithographic printing plate as disclosed in Example 1. Thus obtained plate was imagewise exposed, developed and treated as disclosed in Example 1. The solid was observed at the 3^{rd} step of Step Tablet

The plate was continuously developed in the same way as described in Example 1. It was possible to develop 310 m² of the plate without any problem, but the developability of the developer was deteriorated (that is, the non-image area could not be removed) when 320 m² was treated with the developer.

| Coating solution for photosensitive layer (V) | |
|---|---|
| Urethane resin (A) | 2.5g |
| Polyvinyl acetal resin (C) | 2.5g |
| Dodecylbenzenesulfonic acid salt of co-condensation product of 3-methoxy-4-diazodiphenylamine/phenoxyacetic acid=1/1 mole and formaldehyde | 1.2g |
| Propane-1,2,3-tricarboxylic acid | 0.05g |
| Phosphoric acid | 0.05g |
| 4-Sulfophthalic acid | 0.05g |
| Tricresil phosphate | 0.25g |
| Half ester of styrene-maleic anhydride copolymer with n-hexanol | 0.1g |
| Victoria Pure Blue BOH | 0.18g |
| Megafac F-177 (Dainippon Ink and Chemicals, Inc.) | 0.015g |
| 1-Methoxy-2-propanol | 20g |
| Methanol | 40g |
| Methyl ethyl ketone | 40g |
| Ion exchanged water | 1g |

| Developer solution (II) | |
|---|---|
| Sodium sulfite | 1g |
| Benzyl alcohol | 40g |
| Triethanolamine | 10g |
| Monoethanolamine | 15g |
| Sodium isopropylnaphthalenesulfonate | 12g |
| Ion exchanged water | 1000g |

### Example 6

The preparation method disclosed in Example 1 was repeated, except that "Coating solution for photosensitive layer (VI)" was substituted for "Coating solution for photosensitive layer (I)" to obtain a presensitized plate useful for making a lithographic printing plate as disclosed in Example 1. Thus obtained plate was imagewise exposed, developed and treated as disclosed in Example 1. The solid was observed at the 3^{rd} step of Step Tablet

The plate was continuously developed in the same way as described in Example 1. It was possible to develop 270 m² of the plate without any problem, but the developability of the developer was deteriorated (that is, the non-image area could not be removed) when 280 m² was treated with the developer.

| Coating solution for photosensitive layer (VI) | |
|---|---|
| Urethane resin (A) | 5g |
| Dodecylbenzenesulfonic acid salt of condensation product of 4-diazodiphenylamine and formaldehyde | 1.2g |
| Propane-1,2,3-tricarboxylic acid | 0.05g |
| Phosphoric acid | 0.05g |
| 4-Sulfophthalic acid | 0.05g |
| Tricresil phosphate | 0.25g |
| Half ester of styrene-maleic anhydride copolymer with n-hexanol | 0.1g |
| Victoria Pure Blue BOH | 0.18g |
| Megafac F-177 (Dainippon Ink and Chemicals, Inc.) | 0.015g |
| 1-Methoxy-2-propanol | 20g |
| Methanol | 40g |
| Methyl ethyl ketone | 40g |
| Ion exchanged water | 1g |

### Comparative example 1

A presensitized plate useful for a lithographic printing plate was prepared as described in Example 2 and the plate was imagewise exposed to light as described in Example 2.

Then, the plate was immersed in a 5 L developer having components shown in "Developer composition (III)" for 10 seconds and immediately washed with water. Next, the plate was treated with the gum shown as "Coating solution for desensitizing to grease (I)" using an automatic gumming up machine (G-800H, Fuji Photo Film Co. Ltd.) to obtain a lithographic printing plate. The solid was observed at the 2^{nd} step of Step Tablet

Then the plate was printed using SOR-M printer (Heidelberg) and Geos (N) black ink (Dainippon Ink and Chemicals, Inc.) on quality paper to obtain 50,000 good prints.

The plate was continuously developed by the method described above. It was possible to develop 120 m² of the plate without any problem, but the developability of the developer was deteriorated (that is, the non-image area could not be removed) when 130 m² was treated with the developer.

| Developer composition (III) | |
|---|---|
| Sodium sulfite | 1g |
| Benzyl alcohol | 40g |
| Triethanolamine | 16g |
| Sodium isopropylnaphthalenesulfonate | 12g |
| Ion exchanged water | 1000g |

The method for preparing a lithographic printing plate comprising; imagewise exposing a negative-working presensitized plate useful for making a lithographic printing plate having a specific photosensitive layer on a substrate and developing the imagewise exposed plate with an aqueous alkaline developer comprising an alkanolamine in a specific amount provides an effect to keep the ability of the developer high and the lithographic printing plate without deterioration of printing durability and sensitivity. of the lithographic printing plate.

## Claims

1. A method for preparing a lithographic printing plate comprising:
imagewise exposing a negative-working presensitized plate useful for making a lithographic printing plate having a photosensitive layer comprising (a) a diazo resin and (b) an organic polymer compound on a substrate and
developing the imagewise exposed plate with an aqueous alkaline developer comprising at least one alkanolamine in an amount of 200 mmol/L or more,
wherein said (b) organic polymer compound has at least one modified polyvinyl acetal resin comprising at least one acid group.

2. A method for preparing a lithographic printing plate comprising:
imagewise exposing a negative-working presensitized plate useful for making a lithographic printing plate having a photosensitive layer comprising (a) a diazo resin and (b) an organic polymer compound on a substrate and
developing the imagewise exposed plate with an aqueous alkaline developer comprising at least one alkanolamine in an amount of 200 mmol/L or more,
wherein said (b) organic polymer compound has at least one modified polyurethane resin comprising at least one acid group.

3. The method of claim 1 or 2, wherein the acid value of the polyvinyl acetal resin or polyurethane resin is in the range of 0.05 to 6 meq/g.

4. The method of any one of claims 1 to 3, wherein said acid group comprises an acidic hydrogen atom of which the acid dissociation constant (pKa) is 7 or less.

5. The method of any one of claims 1 to 3, wherein said acid group is selected from the group consisting of -COOH, -SO₂NHCOO-, -CONHSO₂-, -CONHSO₂NH-, and -NHCONHSO₂-.

6. The method of any one of claims 1 to 5, wherein said alkanolamine is represented by the following general formula: 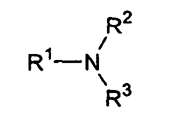 wherein R¹, R², and R³ each independently represents -H, -C₂H₄OH, or -C₃H₆OH provided that R¹, R², and R³ do not simultaneously represent H.

7. The method of any one of claims 1 to 6, wherein said alkanolamine is selected from the group consisting of monoethanolamine, diethanolamine, and triethanolamine.

8. The method of any one of claims 1 to 7, wherein the total amount of said alkanolamine in the aqueous alkaline developer is in the range of 200 to 1000 mmol/L.

## Patentansprüche

1. Verfahren zur Herstellung einer Lithographie-Druckplatte umfassend:
bildweises Belichten einer negativ-arbeitenden vorsensibilisierten Platte, die zur Herstellung einer Lithographie-Druckplatte nützlich ist, die auf einem Substrat eine fotoempfindliche Schicht aufweist, welche (a) ein Diazoharz und (b) eine organische Polymerverbindung umfaßt, und
Entwickeln der bildweise belichteten Platte mit einem wäßrigen alkalischen Entwickler, der zumindest ein Alkanolamin in einer Menge von 200 mmol/l oder mehr umfaßt,
worin die organische Polymerverbindung (b) zumindest ein modifiziertes Polyvinylacetalharz aufweist, das zumindest eine Säuregruppe umfaßt.

2. Verfahren zur Herstellung einer Lithographie-Druckplatte umfassend:
bildweises Belichten einer negativ-arbeitenden vorsensibilisierten Platte, die zur Herstellung einer Lithographie-Druckplatte nützlich ist, die auf einem Substrat eine fotoempfindliche Schicht aufweist, welche (a) ein Diazoharz und (b) eine organische Polymerverbindung umfaßt, und
Entwickeln der bildweise belichteten Platte mit einem wäßrigen alkalischen Entwickler, der zumindest ein Alkanolamin in einer Menge von 200 mmol/l oder mehr umfaßt,
worin die organische Polymerverbindung (b) zumindest ein modifiziertes Polyurethanharz aufweist, das zumindest eine Säuregruppe umfaßt.

3. Verfahren gemäß Anspruch 1 oder 2, worin der Säurewert des Polyvinylacetalharzes oder des Polyurethanharzes im Bereich von 0,05 bis 6 meq/g liegt.

4. Verfahren gemäß irgendeinem der Ansprüche 1 bis 3, worin die Säuregruppe ein saures Wasserstoffatom umfaßt, deren Säuredissoziationskonstante (pKa) 7 oder kleiner ist.

5. Verfahren gemäß irgendeinem der Ansprüche 1 bis 3, worin die Säuregruppe aus der Gruppe ausgewählt ist bestehend aus -COOH, -SO₂NHCOO-, -CONHSO₂-, -CONHSO₂NH- und -NHCONHSO₂-.

6. Verfahren gemäß irgendeinem der Ansprüche 1 bis 5, worin das Alkanolamin durch die folgende allgemeine Formel dargestellt wird: 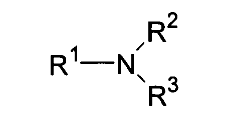 worin R¹, R² und R³ jeweils unabhängig voneinander -H, -C₂H₄OH oder -C₃H₆OH darstellen, vorausgesetzt, daß R¹, R² und R³ nicht gleichzeitig H darstellen.

7. Verfahren gemäß irgendeinem der Ansprüche 1 bis 6, worin das Alkanolamin aus der Gruppe ausgewählt ist bestehend aus Monoethanolamin, Diethanolamin und Triethanolamin.

8. Verfahren gemäß irgendeinem der Ansprüche 1 bis 7, worin die Gesamtmenge des Alkanolamins in dem wäßrigen alkalischen Entwickler im Bereich von 200 bis 1.000 mmol/l liegt.

## Revendications

1. Procédé de préparation d'une plaque d'impression lithographique comprenant :
l'exposition à la manière d'une image d'une plaque présensibilisée pour copiage par inversion utile pour fabriquer une plaque d'impression lithographique ayant une couche photosensible comprenant (a) une résine diazo et (b) un composé polymère organique sur un substrat et
le développement de la plaque exposée à la manière d'une image avec un révélateur alcalin aqueux comprenant au moins une alcanolamine en une quantité de 200 mmoles/L ou davantage,
dans lequel ledit (b) composé polymère organique a au moins une résine de polyvinylacétal modifié comprenant au moins un groupe acide.

2. Procédé de préparation d'une plaque d'impression lithographique comprenant :
l'exposition à la manière d'une image d'une plaque présensibilisée pour copiage par inversion utile pour fabriquer une plaque d'impression lithographique ayant une couche photosensible comprenant (a) une résine diazo et (b) un composé polymère organique sur un substrat et
le développement de la plaque exposée à la manière d'une image avec un révélateur alcalin aqueux comprenant au moins une alcanolamine en une quantité de 200 mmoles/L ou davantage,
dans lequel ledit (b) composé polymère organique a au moins une résine de polyuréthane modifié comprenant au moins un groupe acide.

3. Procédé selon la revendication 1 ou 2, dans lequel l'indice d'acide de la résine de polyvinylacétal ou de la résine de polyuréthane se situe dans la plage de 0,05 à 6 méq/g.

4. Procédé selon l'une quelconque des revendications 1 à 3, dans lequel ledit groupe acide comprend un atome d'hydrogène acide dont la constante de dissociation acide (pKa) est de 7 ou inférieure.

5. Procédé selon l'une quelconque des revendications 1 à 3, dans lequel ledit groupe acide est sélectionné dans le groupe constitué par -COOH, -SO₂NHCOO-, -CONHSO₂-, -CONHSO₂NH-, et -NHCONHSO₂-.

6. Procédé selon l'une quelconque des revendications 1 à 5, dans lequel ladite alcanolamine est représentée par la formule générale suivante : 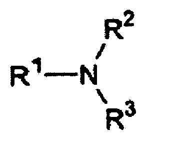 dans laquelle R¹, R², et R³ représentent chacun indépendamment -H, -C₂H₄OH, ou -C₃H₆OH à la condition que R¹, R² et R³ ne représentent pas simultanément H.

7. Procédé selon l'une quelconque des revendications 1 à 6, dans lequel ladite alcanolamine est sélectionné dans le groupe constitué par la monoéthanolamine, la diéthanolamine, et la triéthanolamine.

8. Procédé selon l'une quelconque des revendications 1 à 7, dans lequel la quantité totale de ladite alcanolamine dans le révélateur alcalin aqueux se situe dans la plage de 200 à 1000 mmoles/L.
